# EUROPEAN PATENT SPECIFICATION

(11) **EP 0 651 432 B1**
(45) Date of publication and mention of the grant of the patent: **07.04.1999**
(21) Application number: 94306952.6
(22) Date of filing: 22.09.1994
(51) Int. Cl.: H01L 21/205, B01J 4/00

(54) **Method of feeding gas into a chamber**
Verfahren zum Zuführen von Gasen in eine Reaktions- bzw. Niederschlagskammer
Procédé pour alimenter une chambre de réaction/déposition de gaz

(30) Priority: 27.10.1993 JP 268689/93
(43) Date of publication of application: 03.05.1995
(73) Proprietor: Kiyohara, Masako, Kumamoto-shi Kumamoto-ken (JP)
(72) Inventor: Minami, Yukio, Nishi-ku, Osaka (JP); Ikeda, Nobukazu, Nishi-ku, Osaka (JP)
(74) Representative: Smith, Norman Ian

(56) References cited:
- DD-A- 206 854
- DE-C- 3 537 544
- US-A- 4 545 136
- PATENT ABSTRACTS OF JAPAN, unexamined applications, C field, vol. 14, no. 242, May 23, 1990 THE PATENT OFFICE JAPANESE GOVERNMENT page 107 C 721; & JP-A-02 063 543 (NEC)
- PATENT ABSTRACTS OF JAPAN, unexamined applications, E field, vol. 6, no. 251, December 10, 1982 THE PATENT OFFICE JAPANESE GOVERNMENT page 150 E 147; & JP-A-57 152 126 (SUWA SEIKOSHA)

## Description

The present invention is mainly for use in semiconductor manufacture and relates to an improvement in the method of feeding gas into the deposition chamber so as to be capable of suppressing pressure fluctuations when the gas feed is changed.

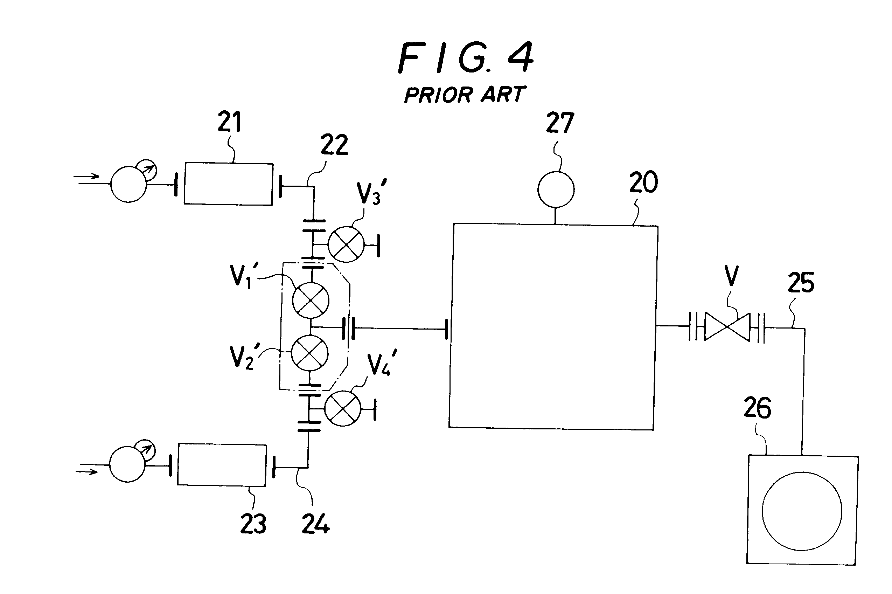

Figure 4 is a schematic block diagram showing an example of gas piping system at present in use in a semiconductor manufacturing plant. This piping system comprises a processing or deposition chamber 20, a reactive gas feed line 22 consisting of a chamber pressure regulator 21 and a line changeover valve V₁' i.e. a valve capable of opening and closing the line to the transmission of gas, an inert gas feed line 24 consisting of a chamber pressure regulator 23 and a line changeover valve V₂', a vacuum exhaust line 25 connected to the chamber 20, and a vacuum pump 26 connected to the vacuumexhaust line 25.

V₃' and V₄' are shunt valves for vent pipe connected to the primary side of the line changeover valves V₁', V₂'; 27 is a vacuum gauge connected to the chamber, and V is a switch valve placed in the vacuum exhaust line 25.

In this gas pipeing system, into the chamber 20 evacuated and exhausted by the vacuum pump 26, reactive gas is supplied from the reactive gas feed line 22 and inert gas from the inert gas feed line 24, alternately, thereby processing to form a film on a wafer in the chamber 20. The flow rate of reactive gas and inert gas supplied into the chamber 20 is controlled by the chamber pressure regulators 21, 23 placed in the lines 22, 24 so that the pressure in the chamber 20 may be a pressure suited to film forming process.

Along with the trend of high integration of semiconductors the film thickness of the wafer now needs to be thin, and it is difficult to control the film thickness. One of the factors to disturb the film thickness is pressure fluctuations in the chamber at the time of changeover of the gas feed lines.

In the conventional gas piping system, the flow rate of gas is controlled by the chamber pressure regulars 21, 23 so that the pressure in the chamber 20 may be kept at a set pressure. However, when the gas feed lines 22, 24 are changed over, inevitably, pressure fluctuations occur in the chamber 20. As a result, the film thickness of the wafer varies, or plasma fails to occur in the chamber 20. It took a considerably long time until the pressure in the chamber 20 is stabilised, and a time loss was caused.

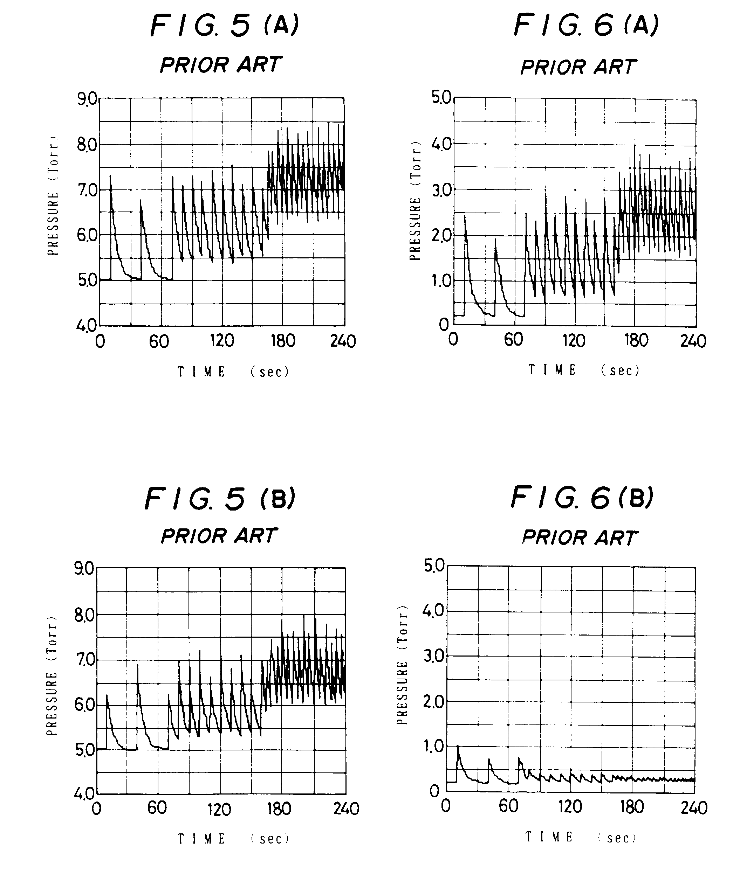

Figures 5 to 8 are graphs showing test results of pressure fluctuation tests of the chamber 20 at the time of line changeover by using the conventional gas piping line.

That is, the pressure fluctuation tests were executed by combining the parameters as shown in Table 1 in order to check for factors of pressure fluctuations in the chamber 20 at the time of line changeover.

**TABLE 1**

| **Parameter** | **Setting** | | |
|---|---|---|---|
| Vacuum Pressure in Chamber | 760, 500, 100, 50, 10, 5, 1, 0.2 (Torr) [1 Torr = 133 Pa] | | |
| Vent line | Yes or No | | |
| Chamber pressure regulator | Reactive gas feed line | Mass flow controller | Direct touch type metal diaphragm valve |
| | Inert gas feed line | Mass flow controller | Direct touch type metal diaphragm valve |
| Line change over interval | 60, 30, 10, 5 (scc) | | |

In the pressure fluctuation tests, direct touch type metal diaphragm valves were used as line changeover valves V₃', V₄' for vent pipe. Such direct touch valves are described in my co-pending EP-A-0 651 190. The valves V₁', V₂', V₃' are air driven valves, which were opened and closed by controlling the supply of valve drive air through solenoid valve (not shown).

Where the vent line is provided, the line changeover valve V₁', and line changeover valve V₂' and shunt valve V₃' are opened and closed alternately and simultaneously. At this time, the gas feed pattern is as follows: (1) when the gas in reactive gas feed line 22 is supplied into the chamber 20, the gas in the inert gas feed line 24 is discharged by the shunt valve V₄', and (2) when the gas in the inert gas feed line 24 is supplied into the chamber 20, the gas in the reactive gas feed line 22 is discharged by the shunt valve V₃'.

Furthermore, where the vent line is not provided, only the line changeover valves V₁', V₂' are opened and closed alternately (the shunt valves V₃', V₃' are normally closed. In this case, the gas feed pattern is as follows: (1) when the gas in the reactive gas feed line 22 is supplied into the chamber 20, the gas in the inert gas feed line 24 is sealed in the line, and (2) when the gas in the inert gas feed line 24 is supplied into the chamber 20, the gas in the reactive gas feed line 22 is sealed in the line.

The pressure fluctuation test at the time of line changeover was conducted in the following procedure. First, the line changeover valves V₁', V₂' are closed, and the chamber 20 (210 mm by 210 mm by 210 mm) is evacuated and exhausted by the vacuum pump 26.

Consequently, from the reactive gas feed line 22, gas (N2 gas: primary pressure is 1.0 kgf/cm²G) is supplied into the chamber 20, and the flow rate of the chamber pressure regulator 21 is adjusted so that the set pressure may be established in the chamber 20, and it is confirmed that the vacuum pressure in the chamber 20 is stabilised.

Furthermore, when the pressure in the chamber 20 is stabilised, the gas feed into the chamber 20 is changed from the reactive gas feed line 22 into the inert gas feed line 24, and the flow rate of the chamber pressure regulator 23 is adjusted so that a set pressure may be established in the chamber 20, and it is confirmed that the vacuum pressure in the chamber 20 is stablilised.

The vacuum pressure in the chamber 20 is set at the same value (±0.5%) between when the gas is supplied through the reactive gas feed line 22 and when the gas is supplied through the inert gas feed line 24.

When these preparatory steps are over, the gas is supplied into the chamber 20 through the reactive gas feed line 22, and it is confirmed that the pressure in the chamber 20 is stabilised. When the pressure in the chamber 20 is stabliised, the gas feed lines 22, 24 are changed over alternately in every specific time, and the pressure fluctuations in the chamber at this time are measured by diaphragm type vacuum gauge 27.

Figure 5 to Figure 8 are graphs showing the test results of pressure fluctuation tests.

More specifically, Figure 5 and Figure 6 are graphic expressions of pressure fluctuations when changing over the lines, and in Figure 5, the set pressure in the chamber 20 is 5 Torr, the interval of line changeover is 30 to 10 to 5 seconds, and mass flow controllers are used as the chamber pressure regulators 21, 23. In Figure 6, the set pressure in the chamber 20 is 0.2 Torr, the interval of line changeover is 30 to 10 to 5 seconds, and mass flow controllers are used as in the pressure regulators 21, 23. Vent lines are provided in (A) in Figure 5 and (A) in Figure 6, and not provided in (B) in Figure 5 and (B) in Figure 6.

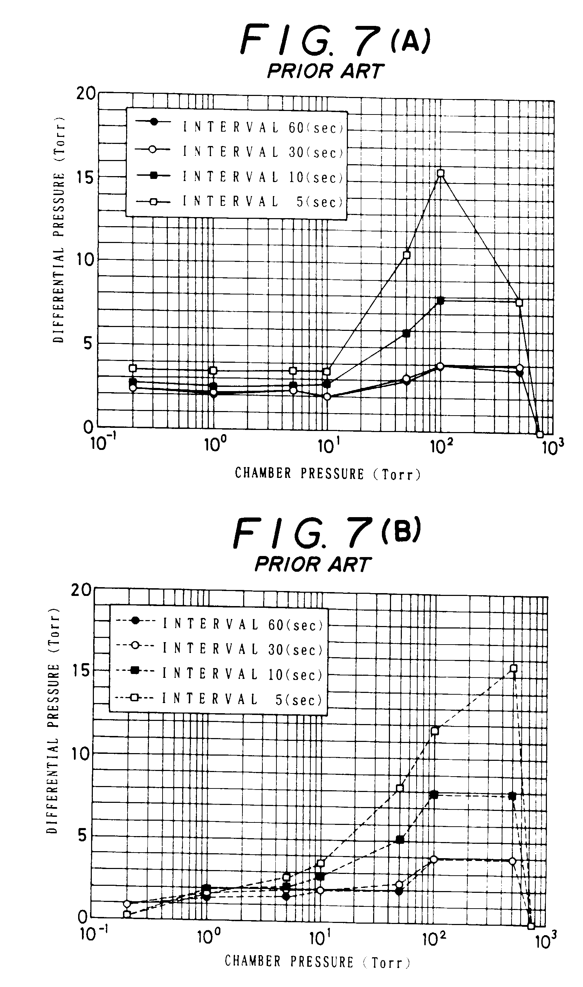

Figure 7 is a graphic expression of pressure difference observed when changing over the lines, relative to the set pressure in the chamber 20, showing the measured values obtained when the interval of line changeover is 60, 30, 10 and 5 seconds, and mass flow controllers are used as the chamber pressure regulators 21, 23. A vent line is provided in (A) in Figure 7, and is not provided in (B) in Figure 7.

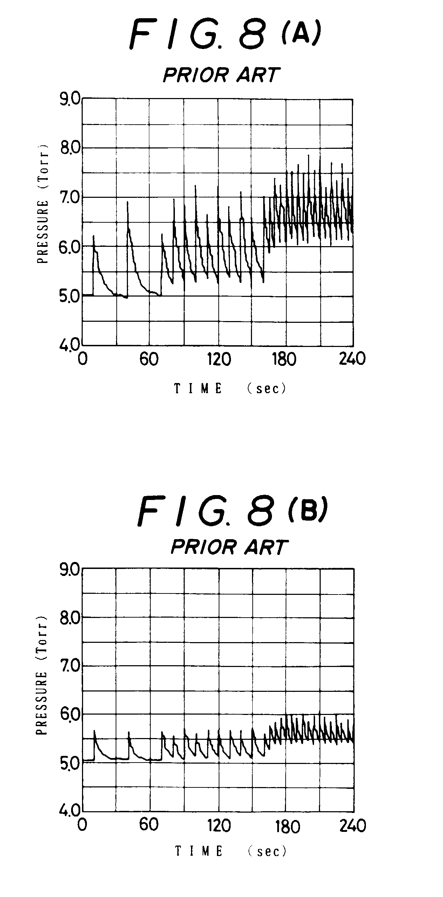

Figure 8 is a graphic expression of pressure fluctuations observed when the chamber pressure regulators 21, 23 are changed, a vent line is provided, and the interval of line changeover is 30, 10 to 5 seconds. In (A) in Figure 8, mass flow controllers are used as the chamber pressure regulators 21, 23 and in (B) in Figure 8, direct diaphragm type flow regulating valves are used as the chamber pressure regulators 21, 23.

As clear from the test results in graphs in Figure 5 to Figure 8, in the conventional gas piping system, (1) when the pressure in the chamber 20 is vacuum, pressure fluctuations occur in the chamber 20 by changing over the lines (see Figure 5 and Figure 6), (2) in comparison between when the line is changed from the reactive gas feed line 22 to the inert gas feed line 24, and when changed from the inert gas feed line 24 to reactive gas feed line 22, the pressure difference varies (see Figure 5 and Figure 6), (3) the shorter the interval of line changeover, the larger becomes the pressure difference (see Figure 5 and Figure 6), (4) in comparison between the presence and absence of vent line in gas feed system, the pressure difference tends to be smaller in the absence of vent line (see Figure 7), (5) the pressure difference is smaller when the vacuum pressure of the chamber 20 is lower, but a pressure fluctuation about twenty times of the set pressure occurs (see Figure 7), and (6) with the chamber pressure regulators 21,23, the pressure difference is greater in the mass flow controllers than in the direct diaphragm type flow regulating valves (Figure 8).

In the conventional gas piping system, it was practically impossible to suppress the pressure fluctuations in the chamber 20 when changing over the lines.

The invention sets out to solve the above problems, and it is hence a primary object thereof to present a method of feeding gas into chamber capable of suppressing pressure fluctuations in the process chamber when changing over the gas feed lines.

The present inventors after many chamber pressure fluctuation tests on the parameters of chamber vacuum pressure, vent line pressure, line changeover intervals, and others, found that pressure fluctuations in the chamber can be suppressed by evacuating and exhausting the vent line.

The present invention provides a method of feeding different gases alternately into a chamber (3) to form a film on a wafer according to claim 1, the alternate gases being a reaction gas which is fed through a reactive gas feed line (1) comprising a chamber pressure regulator 4 connected to the upstream side of said reactive gas feed line and a line changeover valve (V₁) connected to the downstream side of the reactive gas feed line (1), and being an inert gas which is fed through an inert gas feed line (2) comprising a chamber pressure regulator (5) and a line changeover valve (V)₂ wherein shunt valves (V₃, V₄), are connected to the upstream side of the changeover valves V₁, V₂ of the lines (1, 2) and a vent line (6) is connected to the downstream side of the shunt valves V₃, V₄, the line changeover valve V₁ of the reactive gas feed line 1 and shunt valve V₄ of inert gas feed line (2) being opened and closed together and the line changeover valve V₂ of the inert gas feed line (2) and the shunt valve V₃ of the reactive gas feed line (1) being opened and closed together at specific time intervals while the vent line 6 is evacuated, so that the reactive gas and inert gas may be alternately fed into the chamber (3) from the reactive gas feed line 1 and inert gas feed line (2).

To feed a reactive gas into a chamber, the line changeover valve of the reactive gas feed line and the shunt valve of the inert gas feed line side are opened, while the line changeover valve of the inert gas feed line and the shunt valve of the reactive gas feed line side are closed. In this manner, the reactive gas is supplied from the reactive gas feed line into the chamber. At this time, the flow rate of reactive gas is adjusted by the chamber pressure regulator so that the pressure in the chamber may be suited to film forming process. When supplying reactive gas, since the vent line is exhausted under vacuum the inert gas of the inert gas feed line flows into the vent line side.

On the other hand, to feed an inert gas into the chamber, the line changeover valve of the inert gas feed line and the shunt valve of the reactive gas feed side are opened, while the line changeover valve of the reactive gas feed line and the shunt valve of the inert gas feed line side are closed. In this manner, the inert gas is supplied from the inert gas feed line into the chamber. The flow rate of the inert gas at this time is adjusted by the chamber pressure regulator so that the pressure in the chamber may be suited to film forming process. When feeding inert gas, the vent line is exhausted by vacuum and therefore the reactive gas in the reactive gas feed line flows into the vent line side.

In this way, the reactive gas and inert gas are alternately supplied into the chamebr in every specific time.

The present invention further provides apparatus according to claim 6 for carrying out the above method containing the lines and valves set out above and comprising a vacuum pump in the exhaust lines.

In the invention, since the reactive gas and inert gas are supplied alternately into the chamber while evacuating and exhausting the vent line, the pressure difference is eliminated between the pressure of the line existing when gas is led into the chamber, and the pressure of the line existing when the gas is vented. As a result, if the lines are changed over, the pressure in the chamber does not fluctuate largely, and the pressure fluctuations in the chamber can be suppressed.

In the accompanying drawings:
Figure 1 is a schematic block diagram of gas piping system for executing the gas feed method in accordance with the invention;
Figure 2 is a graph showing the test results of pressure fluctuation test by using the gas piping system in Figure 1, being a graph showing pressure fluctuations in the chamber when changing over the lines while regulating pressure of the vent line.
Figure 3 is a graph showing pressure difference of chamber observed when changing over the lines while regulating pressure of the vent line.
Figure 4 is a schematic block diagram of the known gas piping system already described.
Figure 5 is a graph of pressure fluctuations in the chamber when changing over the lines, showing the test results of pressure fluctuation test by using a conventional gas piping system.
Figure 6 is a graph showing pressure fluctuations in chamber when changing over the lines.
Figure 7 is a graph showing the pressure difference, observed when changing over the lines, with respect to the set pressure in the chamber.
Figure 8 is a graph showing the pressure fluctuations of chamber observed when changing over the lines with the pressure regulator being changed.

Referring now to the drawings, an embodiment of the invention is described in detail below.

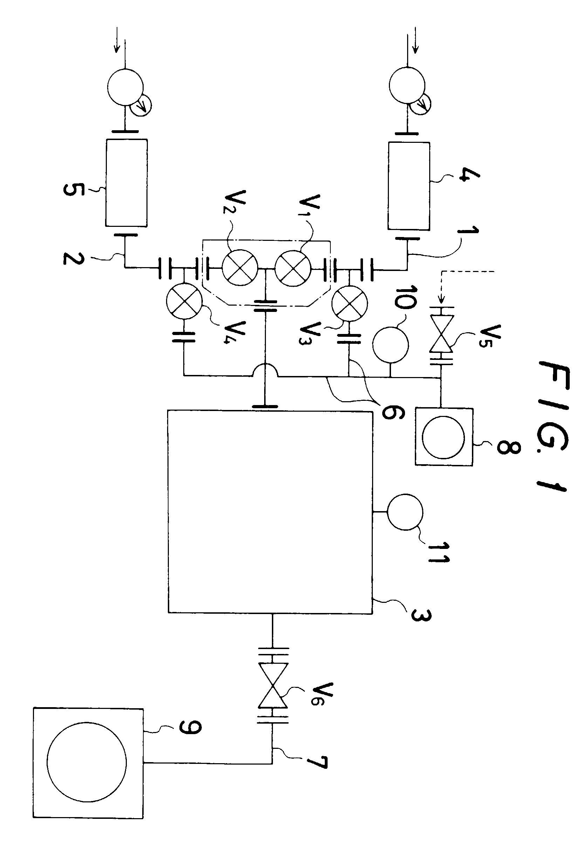

Figure 1 is a schematic block diagram of a gas piping system of a semiconductor manufacturing plant in accordance with one aspect of the invention and in which the method of the invention is carried out. This piping system is an assembly of gas feed system, chamber and vacuum exhaust system. In Figure 1, reference numeral 1 denotes a reactive gas feed line, 2 is an inert gas feed line, 3 is the reaction/deposition chamber, 4 and 5 are chamber pressure regulators, V₁ and V₂ are line changeover valves, V₃ and V₄ are shunt valves for directing gas selectively to vent, 6 is a vent line, V₅ is a vent line pressure regulating valve, 7 is a vacuum exhaust line, 8 and 9 are vacuum pumps, V₆ is a valve, and 10 and 11 are vacuum gauges.

In the reactive gas feed line 1 and inert gas feed line 2, the chamber pressure regulators 4 and 5, and line changeover valves V₁ and V₂ are provided, and downstream side parts (the parts extended from the line changeover valves V₁ and V₂ to the chamber 3) of the lines 1 and 2 connected to the chamber 3 are common lines. Mass flow conrollers are used as the chamber pressure regulators 4 and 5. As the line changeover valves V₁ and V₂, the direct touch type metal diaphragm valves in the structure having the metal diaphragm directly contacting with the valve seat are employed.

The shunt valves V₃ and V₄ for vent are connected as branches to the primary side of the line changeover valves V₁ V₂ of the reactive gas feed line 1 and inert gas feed line 2, and direct diaphragm type valves are used as the shunt values V₃ and V₄.

In the vent line 6, the upstream side is connected to the shunt valves V₃ and V₄ and the downstream side is connected in accordance with the invention to the vacuum pump 8. At the downstream side of the vent line 6, the vent line pressure regulating valve V₅ is connected as a branch in a state released to the atmosphere, and a direct touch type metal diaphragm valve is used as the vent line pressure regulating valve V₅.

The line changeover valves V₁, V₂ and shunt valves V₃, V₄ are air driven vents, and are opened and closed by supplying valve driving air from the solenoid valve (not shown). The line changeover valve V₁ and shunt valve V₄, and line changeover valve V₂ and shunt valve V₃ are opened and closed alternately and simultaneously.

Explained below is the supply of reactive gas and inert gas alternately into the chamber 3 by the gas piping system shown above.

First, to supply reactive gas into the chamber 3, the line changeover valve V₁ and shunt valve V₄ are opened, while line changeover valve V₂ and shunt valve V₃ are closed. In this manner, the reactive gas is supplied from the rective gas feed line 1 into the chamber 3. At this time, the flow rate of the reactive gas is adjusted by the chamber pressure regulator 4 so that the pressure in the chamber 3 may be a pressure suited to wafer film forming process. The vent line 6 is evacuated and exhausted by the vacuum pump 8, and its pressure is controlled to be nearly the same as the pressure in the chamber 3 by adjusting the vent line pressure regulating valve V₅. By evacuating and exhausting the vent line 6, the inert gas in the inert gas feed line 2 flows into the vent line 6 side.

On the other hand, when supplying inert gas into the chamber 3, the line changeover valve V₂ and shunt valve V₃ are opened, while line changeover valve V₁ and shunt valve V₄ are closed. In this manner, the inert gas is supplied from the inert gas feed line 2 into the chamber 3. At this time, the flow rate of the inert gas is adjusted by the chamber pressure regulator 5 so that the pressure in the chamber 3 may be a pressure suited to film forming process. The vent line 6 is evacuated and exhausted by the vacuum pump 8, and its pressure is controlled to be nearly the same as the pressure in the chamber 3 by adjusting the vent line pressure regulating valve V₅. By evacuating and exhausting the vent line 6, the reactive gas of the reactive gas feed line 1 flows into the vent line 6 side.

In this way, by evacuating and exhausting the vent line 6, the reactive gas and inert gas are alternately supplied into the chamber 3 in accordance with a specific and predetermined time sequence.

In the invention, since the reactive gas and inert gas are supplied alternately into the chamber 3 while evacuating and exhausting the vent line 6, the difference is eliminated between the pressure of the line (the line downstream with respect to the chamber pressure regulators 4, 5) serving to feed gas into the chamber 3, and the pressure of the line (the line downstream with respect to the chamber pressure regulators 4, 5 serving to vent gas. As a result, when the lines are changed over, the pressure in the chamber 3 will not fluctuate significantly, and pressure fluctuations in the chamber 3 can be suppressed.

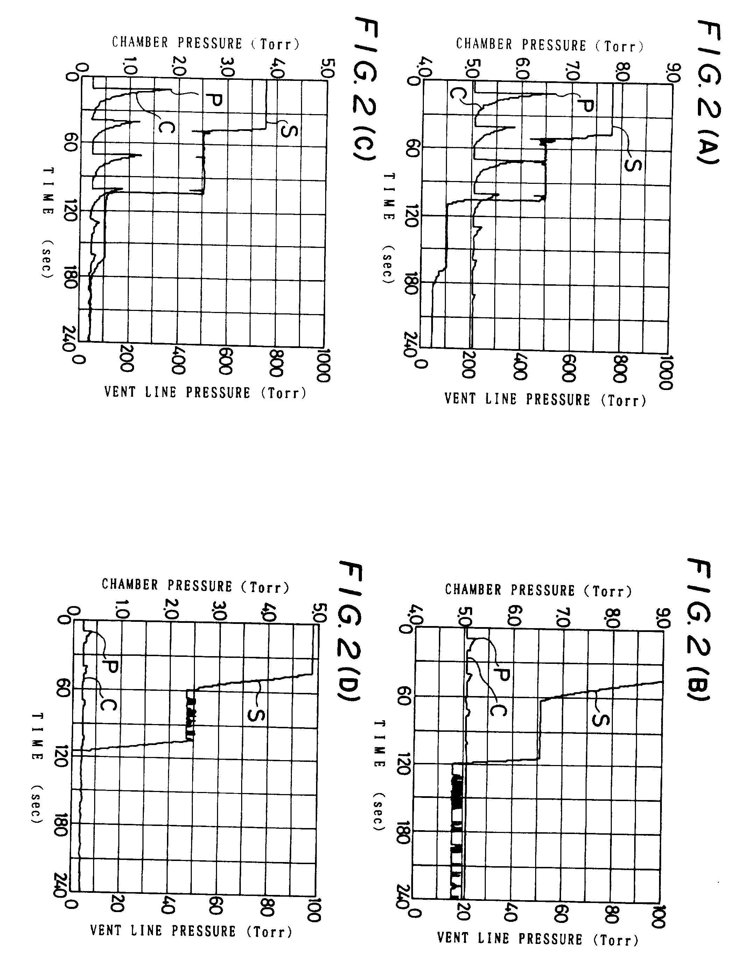

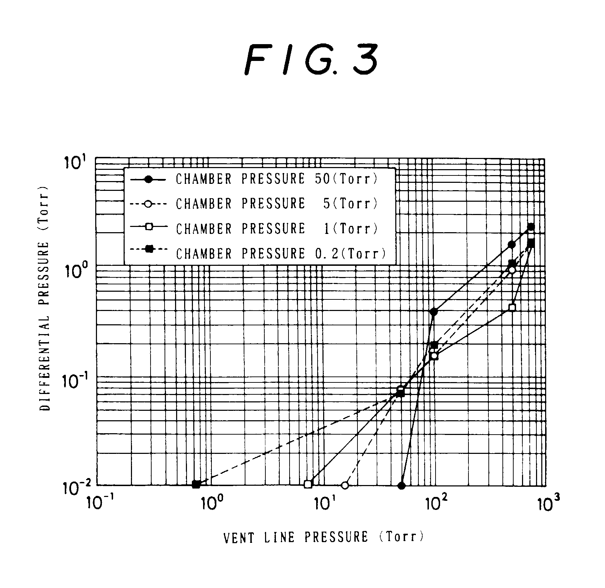

Figures 2 and 3 are graphs showing the rest results obtained when the chamber pressure fluctuations are tested when changing over the lines by using the above-mentioned gas piping system.

That is, the pressure fluctuation tests are conducted by combining the parameters shown in Table 2 below.

**TABLE 2**

| **Parameter** | **Setting** |
|---|---|
| Vacuum pressure in chamber | 50, 5, 1, 0.2 (Torr) |
| Pressure of vent line | 760, 500, 100, 50 and pressure reached when vent line pressure regulating valve is closed (Torr) |
| Chamber pressure regulator | Reactive gas fed line: Mass flow controller |
| | Inert gas feed line: Mass flow controller |
| Vent line | Provided |
| Line changeover interval | 30 (sec), in principle; only at the time of vent line pressure, 10 to 5 (sec) reached |

The pressure fluctuation test upon line changeover was executed in the following procedure. First, the line changeover valves V₁, V₂ are closed, and the chamber 3 (210 mm x 210 mm) is evacuated and exhausted by the rotary pump 9.

Consequently, the line changeover valve V₁ and shunt valve V₄ are opened, while line changeover valve V₂ and shunt valve V₃ are closed. Gas (N₂ gas: primary pressure 1.0 kgf/cm²G) is supplied into the chamber 3 from the reactive gas feed line 1, and the flow rate is adjusted by the chamber pressure regulator 4 so that the set pressure may be established in the chamber 3. Meanwhile, the gas (N₂ gas: primary pressure 1.0 kgf/cm²G) in the inert gas feed line 2 is discharged to the vent line 6 side, and the vent line pressure regulating valve V₅ is opened so that the pressure in the vent line 6 may be set in atmospheric release state.

When the pressure in the chamber 3 is stabilised, the gas feed into the chamber 3 is changed over from the reactive gas feed line 1 into the inert gas feed line 2. It is confirmed that by the same operatin as mentioned above, the set pressure in the chamber 3 and, further, the set pressure in the vent line 6 become the same between when gas is supplied through the reactive gas feed line 1 and when gas is supplied through the inert gas feed line 2.

When this preparatory work is over, gas is supplied into the chamber 3 through the reactive gas feed line 1, and stabilisation of pressure in the chamber 3 is confirmed. When the pressure in the chamber 3 is stabilised, the lines 1, 2 are alternately changed over in every specific time. Parallel to this, the pressure in the vent line 6 is evacuated and exhausted from the atmospheric release state by the vacuum pump 8, and the pressure in the vent line 6 is varied by the vent line pressure regulating valve V₅. At this time, the pressure fluctuations in the chamber 3 are measured by diaphragm type vacuum gauge 10.

Figure 2 and Figure 3 are graphs showing the results of pressure fluctuation tests.

That is, Figure 2 is a graphic expression of pressure fluctuations (curve C) of the chamber 3 when the lines are changed over while regulating the pressure (curve S) of the vent line 6, and Figure 2 (A) shows the case of changing the vent line pressure from 760 to 500, 100 and 50 Torr, with the set pressure of the chamber 3 at 5 Torr, and line changeover interval at 30 sec. In Figure 2 (B), the set pressure in the chamber 3 is 5 Torr, the line changeover interval is 30 to 10 to 5 sec, and the vent line pressure is changed from 100 to 50 Torr, to reached pressure (the pressure obtained when the vent line pressure regulating valve V₅ is closed). In Figure 2 (C), the set pressure in the chamber 3 is 0.2 Torr, the line changeover interval is 30 sec, and the vent line pressure is changed from 760 to 500, 100 and 50 Torr. In Figure 2 (D), the set pressure in the chamber 3 is 0.2 Torr, the line changeover interval is 30 to 10 and 5 sec, and the vent line pressure is changed from 100 to 50 Torr, and reached pressure (the pressure obtained when the vent line pressure regulating valve V₅ is closed).

Figure 3 shows a graph of pressure difference when changing over the lines while regulating pressure of the vent line 6. When the vent line pressure is 50 Torr or more, the vent line pressure regulating valve V₅ is regulated, and when the vent line pressure is 50 Torr or less, the vent line pressure regulating valve V₅ is closed.

In the graph of Figure 2, time 0 to 10 sec. shows the pressure of the reactive gas feed line 1, and the peak P at 10 sec. shows the pressure fluctuation observed when the line is changed from the reactive gas feed line 1 to the inert gas feed line 2. The plotting point of the pressure difference of the graph in Figure 3 is the maximum value of the pressure difference observed when the line is changed from the reactive gas feed line 1 to the inert gas feed line 2, or from the inert gas feed line 2 to the reactive gas feed line 1.

As is clear from the graphs in Figure 2 and Figure 3, as the pressure of the vent line 6 changes from the atmospheric pressure toward vacuum, the pressure fluctuation in the chamber 3 becomes smaller. Therefore, by evacuating and exhausting the vent line 6, the pressure fluctuation in the chamber 3 in line changeover can be suppressed.

In the above embodiment, mass flow controllers are used as chamber pressure regulators 4, 5, but it is confirmed by the tests that in the method of the invention, if th chamber pressure regulators 4, 5 are replaced by others such as direct touch type metal diaphragm valves or combination of mass flow controller and direct touch type metal diaphragm valve, the pressure fluctuations in the chamber 3 can be suppressed.

Also it is confirmed by tests that in the method of the invention, if the inner volume of the line between the mass flow controllers and the line changeover valves V₁, V₂ is changed, the pressure fluctuations in the chamber3 can be suppressed.

In the invention, as described herein, shunt valves are connected to the primary side of the line changeover valves of the reactive gas feed line and inert gas feed line, and the vent line is connected to the shunt valves. The line changeover valve of the reactive gas feed line side and the shunt valve of the inert gas feed line side, and the line changeover valve of the reactive gas feed side line and the shunt valve of the inert gas feed line side are opened and closed simultaneously, and the reactive gas and inert gas are supplied alternately to the chmber from each gas feed line, while evacuating and exhausting the vent line.

As a result, the difference is eliminated between the pressure of the line for feeding gas into the chamber and the pressure of the line for venting gas, and if the lines are changed over, the pressure in the chamber does not vary significantly, so that the quality of the semiconductor may be enhanced.

## Claims

1. A method of feeding different gases alternately into a chamber (3) to form a film on a wafer, the alternate gases being a reaction gas which is fed through a reactive gas feed line (1) comprising a chamber pressure regulator (4) connected to the upstream side of said reactive gas feed line and a line changeover valve (V₁) connected to the downstream side of the reactive gas feed line (1), and being an inert gas which is fed through an inert gas feed line (2) comprising a chamber pressure regulator (5) and a line changeover valve (V₂), wherein shunt valves (V₃, V₄) are connected to the upstream side of the changeover valves (V₁, V₂) of the reactive gas and inert gas lines (1, 2), respectively, and a vent line (6) is connected to the downstream side of the shunt valves (V₃, V₄), the line changeover valve (V₁) of the reactive gas feed line 1 and shunt valve (V₄) of inert gas feed line (2) being opened and closed together and the line changeover valve (V₂) of the inert gas feed line (2) and the shunt valve (V₃) of the reactive gas feed line (1) being opened and closed together at specific time intervals while the vent line (6) is evacuated, so that the reactive gas and inert gas may be alternately fed into the chamber (3) from the reactive gas feed line (1) and inert gas feed line (2).

2. A method according to Claim 1, wherein a vent line pressure regulating valve (V₅) having the outlet side released to the atmosphere is connected as a branch to the vent line (6), and the pressure in the vent line (6) is regulated by adjusting the opening degree of the vent line pressure regulating valve (V₅).

3. A method according to Claim 1 or 2, wherein the pressure in the chamber (3) is set at 0.2 to 50 Torr (26,6 to 6650 Pa), and the pressure in the evacuated vent line (6) is set at 200 Torr (26600 Pa) or less.

4. A method according to Claim 1, 2 or 3 wherein the chamber pressure regulators (4, 5) are mass flow controllers, and changeover valves (V₁, V₂) and shunt valves (V₃, V₄) are metal diaphragm valves of direct touch type.

5. A method according to Claims 1, 2 or 3, wherein the chamber pressure regulators (4, 5,) changeover valves (V₁, V₂) and shunt valves (V₃, V₄) are metal diaphragm valves of direct touch type.

6. Apparatus for feeding a reactive gas and an inert gas alternately into a chamber (3) to form a film on a wafer by the method of Claim 1, the apparatus comprising a reactive gas feed line (1), a chamber pressure regulator (4) connected to the upstream side of said reactive gas feed line and a line changeover valve (V₁) connected to the downstream side of the reactive gas feed line (1), an inert gas feed line (2), a chamber pressure regulator (5) connected to the upstream side of said inert gas feed line and a line changeover valve (V₂) connected to the downstream side of said inert gas feed line, shunt valves (V₃, V₄), connected to the upstream side of the changeover valves (V₁, V₂) of the reactive gas and inert gas lines (1, 2), respectively, and a vent line (6) located at the downstream side of the shunt valves (V₃, V₄) connecting said shunt valves together, the line changeover valve (V₁) of the reactive gas feed line (1) and shunt valve (V₄) of inert gas feed line (2) being arranged to be opened and closed together and the line changeover valve (V₂) of the inert gas feed line (2) and the shunt valve (V₃) of the reactive gas feed line (1) being arranged to be opened and closed together at specific time intervals while the vent line (6) is evacuated, so that the reactive gas and inert gas may be alternately fed into the chamber (3) from the reactive gas feed line (1) and inert gas feed line (2), and further comprising a vacuum pump (8) in vent line (6) for evacuating said vent line (6).

## Patentansprüche

1. Verfahren für die alternierende Einleitung verschiedener Gase in eine Kammer (3) zur Bildung eines Films auf einem Träger, wobei eines der alternierend einzuleitenden Gase ein Reaktionsgas ist, das durch eine Zuleitung (1) für Reaktionsgas geführt wird, die einen Kammerdruckregler (4) einschließt, der mit der stromaufwärtigen Seite der Zuleitung für Reaktionsgas verbunden ist, und die ein Leitungswechselventil (V₁) einschließt, das mit der stromabwärtigen Seite der Zuleitung (1) für Reaktionsgas verbunden ist, und wobei das andere der Gase ein Inertgas ist, das durch eine Zuleitung (2) für Inertgas geführt ist, die einen Kammerdruckregler (5) und ein Leitungswechselventil (V₂) einschließt, wobei Shuntventile (V₃, V₄) mit der stromaufwärtigen Seite der Wechselventile (V₁, V₂) der Reaktions- bzw. Inertgasleitungen (1, 2) verbunden sind und eine Entlüftungsleitung (6) mit der stromabwärtigen Seite der Shuntventile (V₃, V₄) verbunden ist, wobei weiter das Leitungswechselventil (V₁) der Reaktionsgaszuleitung (1) und das Shuntventil (V₄) der Inertgaszuleitung (2) zusammen geöffnet und geschlossen werden und das Leitungswechselventil (V₂) der Inertgaszuleitung (2) und das Shuntventil (V₃) der Reaktionsgaszuleitung (1) in vorgegebenen Zeitintervallen zusammen geöffnet und geschlossen werden, während die Entlüftungsleitung (6) evakuiert ist, so daß das Reaktionsgas und Inertgas aus der Reaktionsgaszuleitung (1) und der Inertgaszuleitung (2) alternierend in die Kammer eingeleitet werden.

2. Verfahren nach Anspruch 1, bei dem ein den Druck in der Entlüftungsleitung regelndes Ventil (V₅) mit einer zur Atmosphäre öffnenden Auslaßseite als Zweigverbindung zur Entlüftungsleitung (6) vorgesehen ist, wobei der Druck in der Entlüftungsleitung (6) durch Einstellen des öffnungsgrades des den Druck in der Entlüftungsleitung regelnden Ventils (V₅) bestimmt wird.

3. Verfahren nach Anspruch 1 oder 2, bei dem der Druck in der Kammer (3) auf 0,2 bis 50 Torr (26,6 bis 66500 Pa) und der Druck in der evakuierenden Entlüftungsleitung (6) auf 200 Torr (26600 Pa) oder weniger festgelegt ist.

4. Verfahren nach Anspruch 1, 2 oder 3, bei dem die Kammerdruckregler (4, 5) Masseflußregler und die Wechselventile (V₁, V₂) schon die Shuntventile (V₃, V₄) Metallmembranventile mit direkter Stellkraftübertragung sind.

5. Verfahren nach Anspruch 1, 2 oder 3, bei dem die Kammerdruckregler (4, 5), die Wechselventile (V₁, V₂) und die Shuntventile (V₃, V₄) Metallmembranventile mit direkter Stellkraftübertragung sind.

6. Vorrichtung für die alternierende Einleitung eines Reaktionsgases und eines Inertgases in eine Kammer (3) zur Bildung eines Films auf einem Träger unter Verwendung des Verfahrens nach Anspruch 1, wobei die Vorrichtung einschließt eine Reaktionsgaszuleitung (1), einen Kammerdruckregler in seiner Verbindung mit der stromaufwärtigen Seite der Reaktionsgaszuleitung, ein Leitungswechselventil (V₁) in seiner Zuordnung zu der stromabwärtigen Seite der Reaktionsgaszuleitung (1), eine Inertgaszuleitung (2), einen Kammerdruckregler (5) in seiner Zuordnung zu der stromaufwärtigen Seite der Inertgaszuleitung, ein Leitungswechselventil (V₂) in seiner Zuordnung zur stromabwärtigen Seite der Reaktionsgaszuleitung, Shuntventile (V₃, V₄) in ihrer Zuordnung zu der stromaufwärtigen Seite der Wechselventile (V₁, V₂) der Reaktionsgaszuleitung (1) bzw. der Inertgaszuleitung (2), eine Entlüftungsleitung (6) in ihrer Anordnung auf der stromabwärtigen Seite der Shuntventile (V₃, V₄) zum Verbinden der Shuntventile miteinander, wobei das Leitungswechselventil (V₁) der Reaktionsgaszuleitung (1) und das Shuntventil (V₄) der Inertgaszuleitung (2) so angeordnet sind, daß sie zusammen geöffnet und geschlossen werden und das Leitungswechselventil (V₂) der Inertgaszuleitung (2) und das Shuntventil (V₃) der Reaktionsgaszuleitung (1) so angeordnet sind, daß sie in bestimmten Zeitintervallen zusammen geöffnet und geschlossen werden, während die Entlüftungsleitung (6) evakuiert ist, so daß Reaktionsgas und Inertgas aus der Reaktionsgasleitung (1) und der Inertgasleitung (2) in die Kammer (3) eingeleitet werden können und wobei schließlich eine Vakuumpumpe (8) in der Entlüftungsleitung (6) vorgesehen ist, um diese Entlüftungsleitung (6) zu evakuieren.

## Revendications

1. Procédé pour alimenter différents gaz en alternance à l'intérieur d'une chambre (3) pour former un film sur une plaquette, les gaz en alternance étant un gaz réactif qui est amené à travers une ligne d'alimentation de gaz réactif (1) comprenant un régulateur de pression de chambre (4) connecté du côté amont de ladite ligne d'alimentation de gaz réactif, et une vanne de changement (V1) connectée du côté aval de la ligne d'alimentation de gaz réactif (1), et un gaz inerte qui est alimenté à travers une ligne d'alimentation de gaz inerte (2) qui comprend un régulateur de pression de chambre (5) et une vanne de changement de ligne (V2), dans lequel des vannes de by-pass (V3, V4) sont connectées du côté amont des vannes de changement (V1, V2) de la ligne de gaz réactif et de la ligne de gaz inerte (1, 2), respectivement, et une ligne de ventilation (6) est connectée du côté aval des vannes de by-pass (V3, V4), la vanne de changement de ligne (V1) de la ligne d'alimentation de gaz réactif (1) et la vanne de by-pass (V4) de la ligne d'alimentation de gaz inerte (2) étant ouvertes et fermées ensemble, et la vanne de changement de ligne (V2) de la ligne d'alimentation de gaz inerte (2) et la vanne de by-pass (V3) de la ligne d'alimentation de gaz réactif (1) étant ouvertes et fermées ensemble à des intervalles temporels spécifiques pendant que la ligne de ventilation (6) est évacuée, de sorte que le gaz réactif et le gaz inerte peuvent être alimentés en alternance à l'intérieur de la chambre (3) depuis la ligne d'alimentation de gaz réactif (1) et depuis la ligne d'alimentation de gaz inerte (2).

2. Procédé selon la revendication 1, dans lequel une vanne de régulation de pression de ligne de ventilation (V5) dont le côté sortie est relâché à l'atmosphère, est connectée sous forme d'un embranchement sur la ligne de ventilation (6), et la pression dans la ligne de ventilation (6) est régulée en ajustant le degré d'ouverture de la vanne de régulation de la pression de ligne de ventilation (V5).

3. Procédé selon l'une ou l'autre des revendications 1 et 2, dans lequel la pression dans la chambre (3) est choisie entre 0,2 et 50 torr, (22,6 à 66550 Pa), et la pression dans la ligne de ventilation évacuée (6) est choisie à 200 torr (26600 Pa) ou moins.

4. Procédé selon l'une des revendications 1, 2 et 3, dans lequel les régulateurs de pression de chambre (4, 5) sont des appareils de commande de débit de masse, et les vannes de changement (V1, V2) et les vannes de by-pass (V3, V4) sont des vannes à diaphragme de métal du type à toucher direct.

5. Procédé selon l'une des revendications 1 2 et 3, dans lequel les régulateurs de pression de chambre (4, 5), les vannes de changement (V1, V2) et les vannes de by-pass (V3, V4) sont des vannes à diaphragme de métal du type à toucher direct.

6. Appareil pour alimenter un gaz réactif et un gaz inerte en alternance dans une chambre (3) pour former un film sur une plaquette, par le procédé de la revendication 1, l'appareil comprenant une ligne d'alimentation de gaz réactif (1), un régulateur de pression de chambre (4) connecté du côté amont de ladite ligne d'alimentation de gaz réactif et une vanne de changement (V1) connectée du côté aval de la ligne d'alimentation de gaz réactif (1), une ligne d'alimentation de gaz inerte (2), un régulateur de pression de chambre (5) connecté du côté amont de ladite ligne de gaz et d'alimentation de gaz inerte, et une vanne de changement de ligne (V2) connectée du côté aval de ladite ligne d'alimentation de gaz inerte, des vannes de by-pass (V3, V4) connectées du côté amont des vannes de changement (V1, V2) de la ligne de gaz réactif et de la ligne de gaz inerte (1, 2), respectivement, et une ligne de ventilation (6) connectée du côté aval des vannes de by-pass (V3, V4) qui connecte lesdites vannes de by-pass ensemble, la vanne de changement de ligne (V1) de la ligne d'alimentation de gaz réactif (1) et la vanne de by-pass (V4) de la ligne d'alimentation de gaz inerte (2) étant agencées de manière à être ouvertes et fermées ensemble, et la vanne de changement de ligne (V2) de la ligne d'alimentation de gaz inerte (2) et la vanne de by-pass (V3) de la ligne d'alimentation de gaz réactif (1) étant agencées de manière à être ouvertes et fermées ensemble à des intervalles temporels spécifiques tandis que la ligne de ventilation (6) est évacuée, de sorte que le gaz réactif et le gaz inerte peuvent être alternativement alimentés dans la chambre (3) depuis la ligne d'alimentation de gaz réactif (1) et la ligne d'alimentation de gaz inerte (2), et comprenant en outre une pompe à vide (8) dans la ligne de ventilation (6) pour évacuer ladite ligne de ventilation (6).
